# FASCICULE DE BREVET EUROPEEN

(11) **EP 1 521 363 B1**
(45) Date de publication et mention de la délivrance du brevet: **12.12.2007**
(21) Numéro de dépôt: 04104837.2
(22) Date de dépôt: 01.10.2004
(51) Int. Cl.: H03H 7/48

(54) **Coupleur intégré**
Integrierter Koppler
Integrated Coupler

(30) Priorité: 03.10.2003 FR 0350643
(43) Date de publication de la demande: 06.04.2005
(73) Titulaire: ST MICROELECTRONICS S.A., 92120 Montrouge (FR)
(72) Inventeur: Dupont, François, TOURS, 37000 (FR); Poveda, Patrick, 37110, VILLEDOMER (FR)
(74) Mandataire: de Beaumont, Michel

(56) Documents cités:
- US-A- 3 296 527
- US-A- 4 603 310
- US-A1- 2002 100 950
- PATENT ABSTRACTS OF JAPAN vol. 012, no. 204 (E-620), 11 juin 1988 (1988-06-11) -& JP 63 002404 A (KOKUSAI ELECTRIC CO LTD), 7 janvier 1988 (1988-01-07)
- PATENT ABSTRACTS OF JAPAN vol. 013, no. 195 (E-754), 10 mai 1989 (1989-05-10) & JP 01 016119 A (NEC CORP), 19 janvier 1989 (1989-01-19)

## Description

La présente invention concerne le domaine des coupleurs dont la fonction est de prélever une partie de la puissance présente sur une ligne principale vers une ligne secondaire à des fins de contrôle et d'asservissement. Des coupleurs sont généralement utilisés dans les systèmes de contrôle de gain en boucle fermé, afin de disposer d'une mesure réelle de la puissance.

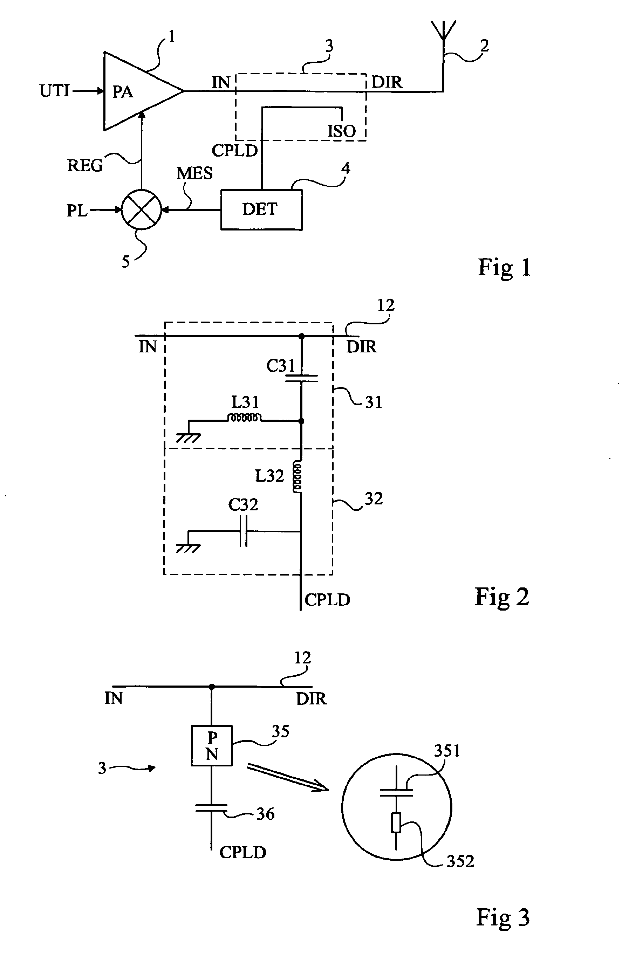

La figure 1 représente, de façon très schématique, un exemple de circuit classique utilisant un coupleur. Cet exemple concerne l'asservissement d'un amplificateur de puissance 1 (PA) d'amplification d'un signal utile UTI à destination d'une antenne 2 de transmission. Dans ce genre d'application, on souhaite asservir la puissance d'émission sur une consigne de puissance PL. Un coupleur 3 est intercalé entre la sortie de l'amplificateur 1 et l'antenne 2 pour extraire une information proportionnelle à la puissance réellement émise. Cette information est exploitée par un détecteur 4 (DET) fournissant une valeur mesurée MES à un comparateur 5 par rapport à la puissance requise PL. Le comparateur 5 fournit un signal d'asservissement REG à l'amplificateur 1.

On connaît essentiellement deux grandes catégories de coupleurs. Une première catégorie concerne les coupleurs dits distribués qui sont réalisés à partir de lignes de transmission couplées. Une deuxième catégorie concerne les coupleurs à éléments localisés, à base de condensateurs et d'inductances.

Les coupleurs distribués sont directifs, c'est-à-dire qu'ils détectent le sens de la puissance mesurée et sont sensibles aux variations dimensionnelles des lignes. De tels coupleurs sont encombrants en raison de la taille des lignes devant être réalisées, surtout pour des applications radiofréquences (de plusieurs centaines de MHz à quelques GHz).

Les coupleurs à éléments localisés sont non directifs. Ils ont l'avantage d'avoir une large bande passante et d'être plus compacts.

Comme l'illustre la figure 1, un coupleur se définit par quatre ports ou bornes IN, DIR, CPLD et ISO. Les bornes IN et DIR sont sur la ligne principale tandis que les bornes CPLD et ISO définissent la ligne secondaire couplée. En figure 1, la borne IN est côté amplificateur de puissance 1 tandis que la borne DIR est côté antenne 2. La borne CPLD est la borne sur laquelle est prélevée l'information proportionnelle à la puissance dans la ligne principale. Dans un coupleur non directif, auquel s'applique la présente invention, les bornes IN et DIR sont confondues et la borne ISO n'existe généralement pas.

Les paramètres principaux d'un coupleur non directif sont:
le facteur de couplage (généralement de l'ordre de 10 à 30 dB) qui correspond à la perte de transmission entre les ports IN et CPLD (l'autre port étant chargé par une impédance normalisée, généralement 50 Ohms) ; et
les pertes d'insertion dans la bande passante souhaitée qui correspondent à la perte de transmission entre les ports IN et DIR (l'autre port étant chargé par une impédance normalisée, généralement 50 Ohms) et que l'on recherche les plus faibles possibles (inférieures à 1 dB et de préférence de l'ordre de 0,5 dB) pour minimiser l'affaiblissement du signal utile par la présence du coupleur.

La figure 2 représente le schéma électrique d'un coupleur non directif classique à éléments localisés. Un tel coupleur est essentiellement constitué de l'association de deux cellules 31 et 32 constituant des filtres respectivement passe haut et passe bas. La cellule 31 comporte un condensateur C31 dont une première électrode est connectée à la ligne 12 de transmission (bornes IN et DIR confondues) et dont une deuxième électrode est connectée, par une inductance L31 à la masse. La deuxième électrode du condensateur C31 constitue également une borne d'entrée de la cellule 32 formée d'une inductance L32 reliant cette deuxième électrode à la borne CPLD, la borne CPLD étant par ailleurs reliée par un condensateur C32 à la masse.

Un inconvénient des coupleurs à éléments localisés passifs tels que celui illustré par la figure 2 est lié aux dispersions (de l'ordre de 20 %) des composants inductifs et capacitifs lors de leur fabrication. De telles dispersions se retrouvent sur les paramètres du coupleur, qui sont donnés pour une bande de fréquences de fonctionnement.

Théoriquement, il est également possible de réaliser des filtres passe haut et passe bas à base d'éléments résistifs et capacitifs pour former un coupleur. Toutefois, le nombre d'étages (ordre des filtres) requis conduit, en pratique, à une taille rédhibitoire. De plus, le problème de dispersion est également présent pour des résistances.

Mais surtout, de telles structures ne sont, en pratique, pas intégrables dans des applications à fréquences élevées (supérieure à la centaine de MHz) que vise plus particulièrement la présente invention, en raison des faibles valeurs requises, notamment pour les condensateurs (inférieures au picofarad).

La présente invention vise à proposer une nouvelle architecture de coupleur intégrable.

L'invention vise plus particulièrement à proposer un coupleur non directif dont les paramètres s'affranchissent des problèmes de dispersion des coupleurs à éléments localisés classiques.

L'invention vise également à permettre une fixation aisée et précise des valeurs des composants du coupleur.

Pour atteindre ces objets et d'autres, la présente invention prévoit un coupleur non directif comportant une jonction semiconductrice en série avec un condensateur, la jonction semiconductrice étant réalisée pour que la fréquence seuil en deçà de laquelle elle a un comportement de redresseur soit inférieure à la fréquence de travail du coupleur

Selon un mode de réalisation de la présente invention, ladite jonction semiconductrice est réalisée dans une couche épitaxiée dont l'épaisseur conditionne la fréquence seuil à partir de laquelle la jonction n'a pas de fonction de redressement.

Selon un mode de réalisation de la présente invention, ledit condensateur a une valeur supérieure à 10 picofarads.

Selon un mode de réalisation de la présente invention, la jonction semiconductrice est dimensionnée pour présenter, à la fréquence de travail du coupleur, une capacité série de l'ordre de quelques centaines de femtofarads et une résistance série de l'ordre de quelques dizaines d'Ohms.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1 et 2 qui ont été décrites précédemment sont destinées à exposer l'état de la technique et le problème posé ;
la figure 3 représente le schéma d'un mode de réalisation d'un coupleur selon la présente invention ;
la figure 4 représente un coupleur selon l'invention connecté à un détecteur d'une boucle d'asservissement du type de celle illustrée en figure 1 ;
la figure 5 représente, par une vue en coupe très schématique, un exemple de réalisation d'un coupleur dans une tranche de silicium selon la présente invention.

Les mêmes éléments ont été désignés par les mêmes références aux différentes figures. Pour des raisons de clarté, seuls les constituants qui sont nécessaires à la compréhension de l'invention ont été représentés aux figures et seront décrits par la suite. En particulier, l'exploitation faite des mesures réalisées par un coupleur selon l'invention n'a pas été détaillée, celle-ci s'appliquant quel que soit le type de mesures effectuées et quelle que soit la ligne de transmission sur laquelle est raccordé le coupleur.

Une caractéristique de la présente invention est de réaliser un coupleur intégré sous la forme d'une jonction semiconductrice (PN) en série avec un condensateur.

La figure 3 représente un mode de réalisation d'un coupleur 3 selon la présente invention.

Une jonction PN 35 est reliée par une première borne (indifféremment P ou N) à la ligne 12 de transmission (bornes IN et DIR confondues) tandis que son autre borne est connectée à une première électrode d'un condensateur 36 dont l'autre électrode définit la borne CPLD du coupleur.

Selon l'invention, la jonction PN 35 est utilisée non pas en élément de redressement mais, aux fréquences souhaitées pour le fonctionnement du coupleur, pour constituer une capacité 351 en série avec une résistance 352 toutes deux de très faible valeur. Par très faible valeur, on entend une capacité 351 inférieure au picofarad et une résistance 352 inférieure à 100 Ohms. La jonction PN est donc réalisée de façon à ne pas redresser le signal aux fréquences relativement élevées (supérieure à une centaine de MHz) de fonctionnement choisies pour le coupleur. Selon un exemple préféré, elle est réalisée avec une zone intrinsèque (diode PIN), par exemple, dans une couche épitaxiée.

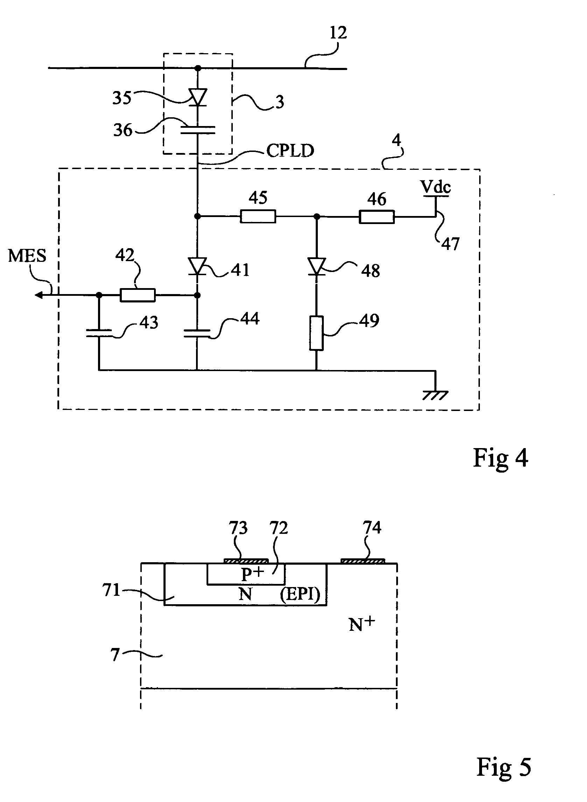

Le condensateur 36 a pour rôle de bloquer la composante continue. Sa valeur est suffisante afin de pouvoir être négligée dans l'association en série avec la capacité 351. De préférence, une valeur supérieure à 10 picofarads respecte ces conditions. Le rôle du condensateur 36 sera mieux compris en relation avec la description de la figure 4 intégrant le coupleur dans son application.

La figure 4 représente un coupleur 3 selon l'invention, représenté sous la forme d'une diode 35 en série avec un condensateur 36, et dont la borne CPLD est connectée à un circuit 4 de détection fournissant un signal de mesure MES à destination d'un comparateur. Le circuit 4 est un circuit classique, par exemple, du type de celui illustré en figure 1. Il comporte un élément de redressement 41 (par exemple, une diode) dont l'anode est connectée à la borne CPLD et dont la cathode est reliée, par l'intermédiaire d'un condensateur 44, à la masse. La cathode de l'élément 41 est par ailleurs reliée, par une résistance 42 à la borne MES qui est reliée, par un condensateur 43 à la masse. Les condensateurs 43 et 44 forment avec la résistance 42 un filtre passe-bas réduisant l'ondulation du signal continu prélevé sur la borne MES.

Le détecteur 4 comporte en outre un circuit de polarisation compensé en température amenant un niveau Vdc sur l'anode de la diode 41. Ce circuit est constitué de deux résistances 45 et 46 en série entre une borne 47 d'application de la tension Vdc et l'anode de la diode 41. Le point milieu de cette association en série est relié à la masse par une diode 48 en série avec une résistance 49. Un tel montage permet d'obtenir un niveau exploitable même pour des faibles puissances de signaux véhiculés sur la ligne principale 12 (inférieures à 0 dBm). Sans cette polarisation, la diode 41 serait bloquée pour de tels niveaux. Toutefois, la présence de cette tension de polarisation impose le recours au condensateur 36 de façon à éviter une polarisation continue de la jonction PN 35 du coupleur 3 qui annulerait le fonctionnement recherché.

La figure 5 illustre un exemple d'intégration dans un substrat de silicium 7 d'une jonction PN 35 d'un coupleur selon l'invention. Pour obtenir l'absence d'effet de redressement recherchée, une région 71 épitaxiée est prévue entre une région 72 dopée P+ et le substrat 7 dopé N+. Il s'agit là d'un exemple, les types de dopage pouvant être inversés. Un premier contact (d'anode) 73 est pris sur la région 72 et un deuxième contact (de cathode) 74 est pris sur la région N+, c'est-à-dire sur le substrat 7.

D'autres configurations de jonction peuvent être envisagées pourvu de respecter l'absence d'effet de redressement aux fréquences de travail souhaitées. Par exemple, la jonction PN pourra être réalisée à partir d'un transistor bipolaire de type NPN monté en diode (base et collecteur reliés).

La fréquence seuil fs à partir de laquelle la jonction PN ne redresse plus le signal est fonction du temps de transit des porteurs (noté tt). Cette fréquence est proportionnelle à l'inverse du temps de transit.

Si le signal de la ligne principale a une fréquence supérieure à la fréquence seuil fs, la tension passe d'une valeur négative à une valeur positive et inversement avec une périodicité inférieure au temps de transit. L'incursion en direct est trop raide pour provoquer un courant et le porteur est évacué par l'alternance négative avant de se recombiner, donc avant de générer un courant redressé. C'est dans cette condition que la jonction PN est assimilée à une capacité en série avec une résistance.

En première approximation, on peut considérer que le temps de transit est essentiellement fonction de l'épaisseur de la couche épitaxiée et du coefficient de diffusion des porteurs. Plus précisément, le temps tt est proportionnel à W² /D, où W représente l'épaisseur de la couche épitaxiée et D le coefficient de diffusion des porteurs.

Pour un coefficient de diffusion des porteurs D de l'ordre de 13 cm²/s, qui constitue une donnée habituelle dans les technologies actuelles, la fréquence fs est approximativement de 1300/W² (fs en MHz et W en µm). En général, dans des dopages faibles utilisés pour réaliser les diodes, le coefficient D de diffusion des porteurs peut être considéré comme constant. Par conséquent, plus l'épaisseur de la couche épitaxiée est faible, plus la fréquence à partir de laquelle la jonction PN n'a pas un comportement redresseur est élevée.

On notera que le niveau de dopage des régions intervient peu sur la fréquence seuil de la jonction PN.

Un exemple d'application particulier de l'invention concerne les coupleurs utilisés dans le domaine de la téléphonie mobile (GSM et DCS). La valeur de la capacité 351 est de l'ordre de quelques centaines de femtofarads. Cette valeur provenant de la réalisation de la diode peut être ajustée en réglant, en fonction de la réponse souhaitée et tout en tenant compte des éventuelles capacités parasites, notamment, le dopage de l'épitaxie, la surface active, l'épaisseur de l'épitaxie en cas de déplétion complète. Une telle valeur est compatible avec des fréquences de l'ordre du GHz.

De la même façon, l'élément résistif 352 est de l'ordre de quelques dizaines d'Ohms, ce qui est compatible avec la réalisation d'une jonction PN et, là encore, ajustable en fonction des caractéristiques souhaitées, en réglant l'écart entre les régions P+ et N+.

On notera que, dans une réalisation intégrée avec le circuit de détection, l'anode de la diode ainsi réalisée constitue directement la borne sur laquelle est raccordée la ligne 12, c'est-à-dire l'antenne et la sortie de l'amplificateur de puissance.

Un avantage d'une jonction PN pour réaliser le coupleur est que, sous forme de coupleur actif, ses paramètres sont contrôlables même pour des faibles valeurs de capacité et de résistance, avec une dispersion nettement plus faible (liée à la technologie des semiconducteurs). Le coupleur "actif" devient donc intégrable. Il peut alors être intégré sur une même puce que celle du circuit de détection (4, figure 4).

Les valeurs à donner aux résistance 352 et capacité 351 par la conformation de la jonction 35 sont déterminées par des outils de modélisation et de simulation habituels en fonction du facteur de couplage et des pertes d'insertion souhaités et/ou acceptables aux fréquences de fonctionnement choisies.

La réalisation pratique d'une diode respectant les contraintes données par l'invention pour former un coupleur est à la portée de l'homme de métier à partir des indications fonctionnelles et de dimensionnement données ci-dessus. De plus, l'invention s'applique aussi bien pour une diode latérale que pour une diode réalisée dans une technologie verticale et quel que soit le type de diode réalisée (diode PN, diode PIN, etc.), pourvu qu'elle soit suffisamment lente par rapport aux fréquences de travail recherchées.

## Revendications

1. Coupleur non directif, **caractérisé en ce qu'**il comporte une jonction semiconductrice (35) en série avec un condensateur (36) pour former un dipôle, la jonction semiconductrice étant réalisée pour que, sans polarisation continue, la fréquence seuil en deçà de laquelle elle a un comportement de redresseur soit inférieure à la fréquence de travail du coupleur.

2. Coupleur selon la revendication 1, dans lequel ladite jonction semiconductrice (35) est réalisée dans une couche épitaxiée (71) dont l'épaisseur conditionne la fréquence seuil à partir de laquelle la jonction n'a pas de fonction de redressement.

3. Coupleur selon la revendication 1 dans lequel ledit condensateur (36) a une valeur supérieure à 10 picofarads.

4. Coupleur selon la revendication 1, dans lequel la jonction semiconductrice (35) est dimensionnée pour présenter, à la fréquence de travail du coupleur, une capacité série de l'ordre de quelques centaines de femtofarads et une résistance série de l'ordre de quelques dizaines d'Ohms.

## Claims

1. A non-directional coupler **characterized in that** it comprises a semiconductor junction (35) in series with a capacitor (36) for forming a dipole, the semiconductor junction being formed so that, without any D.C. bias, the threshold frequency under which it behaves as a rectifier is smaller than the coupler's operating frequency.

2. The coupler of claim 1, wherein said semiconductor junction (35) is formed in an epitaxial layer (71), the thickness of which conditions the threshold frequency from which the junction no longer has a rectifying function.

3. The coupler of claim 1, wherein said capacitor (36) has a value greater than 10 picofarads.

4. The coupler of claim 1, wherein the semiconductor junction (35) is sized to exhibit, at the coupler's operating frequency, a series capacitance on the order of a few hundreds of femtofarads and a series resistance on the order of a few tens of ohms.

## Patentansprüche

1. Ein ungerichteter Koppler, **dadurch gekennzeichnet, dass** er einen Halbleiterübergang (35) in Serie mit einem Kondensator (36) zur Bildung eines Dipols aufweist, wobei der Halbleiterübergang so gebildet ist, dass ohne Gleichstromsvorspannung, die Schwellenfrequenz bei der sie sich als ein Gleichrichter verhält, kleiner ist als die Betriebsfrequenz des Kopplers

2. Der Koppler gemäß Anspruch 1, wobei der Halbleiterübergang (35) in einer epitaxialen Schicht (71) gebildet ist, wobei deren Dicke die Schwellenfrequenz bedingt, ab der die Verbindung keine gleichrichtende Funktion mehr hat.

3. Der Koppler gemäß Anspruch 1, wobei der Kondensator (36) einen Wert größer als 10 Picofarad hat

4. Der Koppler gemäß Anspruch 1, wobei der Halbleiterübergang (35) dimensioniert ist, um bei der Betriebsfrequenz des Kopplers einen Serienkondensator in der Größe von wenigen Hunderten Femtofarad und einen Serienwiderstand in der Größe von wenigen Zehntel Ohm darzustellen.
